# EUROPEAN PATENT SPECIFICATION

(11) **EP 0 323 827 B1**
(45) Date of publication and mention of the grant of the patent: **14.04.1993**
(21) Application number: 89100021.8
(22) Date of filing: 02.01.1989
(51) Int. Cl.: C23C 18/12

(54) **Electronic electrothermal conversion material, its products and method for production thereof**
Elektronisch-elektrothermisches Umwandlungsmaterial, Verfahren zu seiner Herstellung und erzeugte Produkte
Matériau de conversion électronique électrothermique, méthode de fabrication et produit obtenu

(30) Priority: 06.01.1988 CN 88100015
(43) Date of publication of application: 12.07.1989
(73) Proprietor: Kong, De-Kai, Wu Xi Jiang Su (CN)
(72) Inventor: Kong, De-Kai, Wu Xi Jiang Su (CN)
(74) Representative: Grünecker, Kinkeldey, Stockmair & Schwanhäusser Anwaltssozietät

(56) References cited:
- GB-A- 1 517 341
- US-A- 4 252 841
- LE VIDE, vol. 38, no. 218, August/September 1983, pages 409-412, Paris, FR; G. BLANDENET et al.: "Elaboration de couches minces transparentes, resistives et réfléchissantes par le procédé pyrosol"
- THIN SOLID FILMS, vol. 138, no. 2, April 1986, pages 255-265, Elsevier Sequoia, Lausanne, CH; M. FANTINI et al.: "The compositional and structural properties of sprayed SnO2:F thin films"

## Description

The present invention relates to the field of electrothermal conversion material made from semiconductor material, and its products.

The semiconductor electrothermal conversion material nowadays used, i.e. material PTC is sintered by a compound of the barium titanate series. Its shortcomings are: poor heat-conductance, a lower ability to withstand electric voltage, brittleness, complication in manufacture, high cost, acute current variation in use (which may be up to 10⁶) and strict limitation in temperature-rise (about 300°C) due to the restriction by the lower Curie temperature of the PTC material. GB-A-1517341 describes a dielectric substrate consisting of glass and that is coated by spraying tin salt, a dopant and an organic reducing agent as a mist onto its surface, thus improving the heat reflective properties of the material obtained which can also be tempered without cracking. The object of this invention is to avoid the shortcomings of the prementioned prior art and to provide an electronic electrothermal conversion material which is cheaper, easier to produce, highly efficient in electrothermal conversion, fast in raising its temperature, possible to heat without open fire in a certain range of temperatures, which has a lower thermal inertia and which is corrosion-resistant and durable in service, as well as its products and the method for production thereof.

According to this invention the method for the production of the electronic electrothermal conversion material comprises the following steps:
(a) dissolving two kinds of chloride,one of which is tin tetrachloride and the other is any one of
   antimony trichloride, lead chloride, Zinc chloride and indium chloride, into any one of the
   organic liquors: ethyl alcohol, carbinol and acetone;
(b) preparing an aqueous solution of any of ammonium fluoride, hydrofluoric acid and tartaric acid as a reducing agent;
(c) rinsing and dewatering a high-temperature-resistant insulating material, putting it into a container, the temperature of which should be 350° - 550°C, and letting the insulating material reach the same temperature as that of the container;
(d) uniformly atomising the organic liquor from step (a) and the liquor from step (b) by high pressure air;
(e) putting the atomized organic liquor from steps (a) and (d) and the atomized liquor from steps (b) and (d) into the container holding said high-temperature-resistant insulating material whereby fluoric molecules as well as high valent metal oxide, low valent metal oxide and metal single substances, the metals of which correspond to the above-mentioned two kinds of chlorides are produced, which precipitate onto the high-temperature-resistant insulating material to form a conductive semiconductor growth layer.

According to this invention an electronic electrothermal material prepared by the above method and a power body comprising said electronic electrothermal material are also obtained.
Fig. 1 shows one kind of electronic electro-heating material;
Fig. 2 shows the sectional view of a defroster or drying apparatus made of electronic electrothermal conversion material;
Fig. 3 shows two layered electronic electro-heating material;
Fig. 4 shows an electric heating dish made of the material shown in fig 3;
Fig. 5 shows electronic electro-heating material made from KMg(AlSi₃O₁₀)F₂ material;
Fig. 6 shows a sleeve electro-heating element made of the material shown in fig5;
Fig. 7 shows a multilayered super imposed electronic electro-heating material;
Fig. 8 shows an electronic electro-heating material superimposed by mechanical method;
Fig. 9 shows the sectional view of the electronic electro-heating material made of honeycombed high-temperature-resistant insulating material;
Fig. 10 shows the sectional view of another honeycombed electronic electro-heating material;
Fig. 11 shows the electronic electro-heating element made from U shape glass tube or porcelain tube as the high-temperature-resistant insulating material.

The process of preparing the electronic electrothermal conversion material and its products according to this invention is as follows: two kinds of chloride, one of which is tin tertrachloride and the other being any one of following: antimony trichloride, lead chloride, zinc chloride, indium chloride, are separately dissolved in absolute ethyl alcohol or carbinol or acetone and then mixed (to be called solution A): a distilled aqueous solution of ammonium fluoride or hydrofluoric acid or tartaric acid is used as reducing agent (to be called solution B). After rinsing (acid-etch cleaning or alkaline cleaning), water scrubbing, deionized water scrubbing and full dewatering the high-temperature-resistant insulating material is put into a container heated to 350-550°C in which there is no open fire (this container is used as a deposting chamber) and let to reach the same temperature as that of the container; said solutions A and B, atomized uniformly by high pressure air, are put into the depositing chamber; they can either be put in simultaneously or separately whereby firstly solution A and then solution B is put into the chamber; solution A reacts with water to produce gas of hydrogen chloride and high valent metal oxide, the metals of which correspond to the two kinds of chlorides (if the chlorides in solution A are tin tetrachloride and antimony trichloride, tin dioxide and antimony dioxide will be produced) a part of the metal oxides reduces to low valent metal oxide and metal single substances under reaction with the reducing agent (if tin tetrachloride and antimony trichloride are used, the low valent metal oxide and metal single substances are tin monoxide, antimony monoxide and tin, antimony correspondingly); at the same time, fluoric molecules are dissociated; these substantial particles deposit onto the superficial layer of the high-temperature-resistant insulating material (The term "deposition" means that the substantial particles deposit gradually on to surface of a certain body under specified temperature), and a conductive semiconductor growth layer will be formed. Owing to the treatment of rinsing and dewatering the high-temperature-resistant insulating material, the absorption affinity of the surface of the material is very strong and the association between the conductive layer and the superficial layer of the insulating material is firm. Such conductive semiconductor growth layer contains uncomplete metal oxides and fluoric molecules. After ageing treatment, a stable structure is formed; therefore, when it works in the enviroment of dissipating heat, the output power is stable. Once the temperature reduces to room temperature, its resistance is recoverable within allowable range.

Owing to existance of high and low valent metal oxides and metal single substances simultaneously in the electronic electro-heating material, the temperature rises rapidly and may reach 900°C, the optimum working temperature being 300°C or so. If it reaches 500°C, there will be no open fire. The higher the concentration of low valent metal oxides and metal single substances is, the faster will be the speed of electrothermal conversion; the stronger the high-temperature-resistant ability, the worse the transparency of depositing layer (conductive growth layer), but on the contrary, the better the transparency.

Owing to the absence of open fire at working time of such an electronic electro-heating material, a superimposing multiple layer of electronic electro-heating material can be used to obtain large power electronic electro-heating material. The large power means that the temperature can be raised rapidly and the service life can be prolonged under larger average power. As the service life is inversely proportional to the average power per unit area, the large power electronic electro-heating material obtained by superimposition possesses larger power for a superimposed body but takes less part of the power for each layer, so it can realize a rapid rise of temperature and a long service life.

Further detailed description of the electronic electro-heating material and its products according to this invention will be made with reference to the drawings.

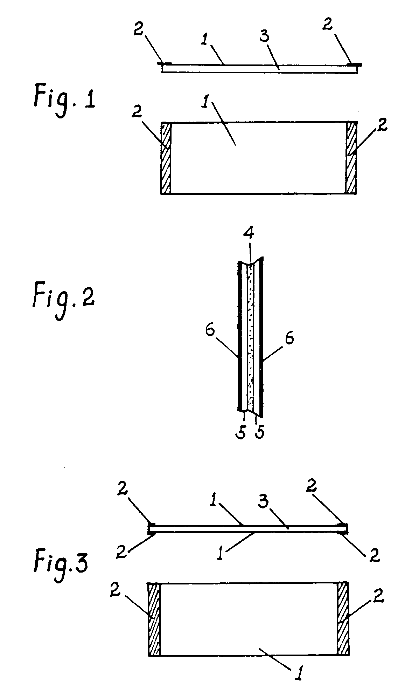

Fig 1 shows an electronic electro-heating material, wherein 1― is the depositing layer (conductive growth layer), 2― the silver oar electrodes and 3― the insulating slice, the chemical component of which is Al₂O₃ or KMg(AlSi₃O₁₀)F₂. 2 is connected to a power source. Such super thin electronic electro-heating material can be used to make for example a high efficiency defroster, heating dish, dry apparatus, iron, and an electro-heating demister.

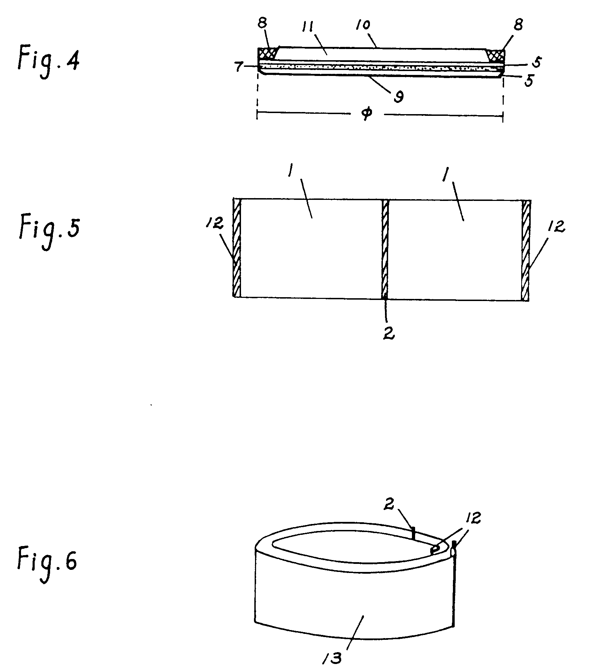

Fig 2 shows the sectional view of a defroster or drying apparatus, wherein 4― is the electronic electro-heating material shown in fig 1, 5― the insulating slice and 6― the metallic case. A uniform thermal field is formed around the surface of "6" at working time; it can uniformly defrost or dry clothing, and can be used as a heat source plate of heating equipment.

Fig 3 shows the electronic electro-heating material, both surfaces of which possess a conductive growth layer, wherein 1 is the depositing face (conductive growth layer), 2 are electrodes and 3 is slice of insulating material.

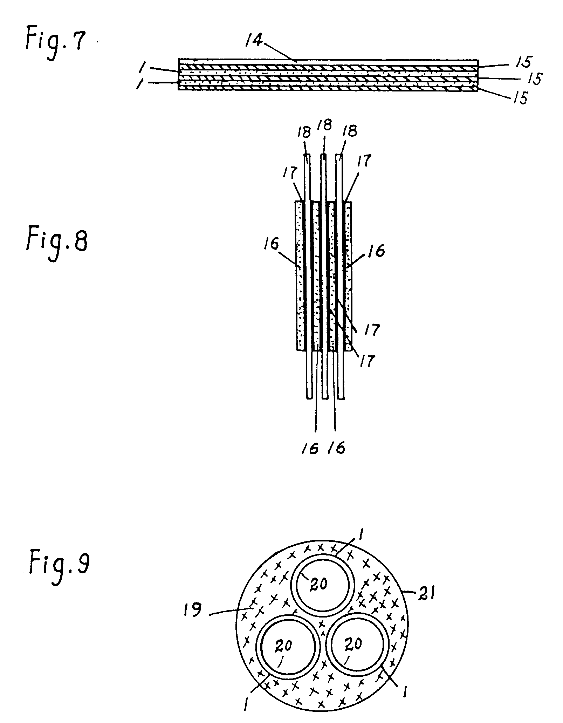

Fig 4 shows the sectional view of a heating dish made of the electro-heating material shown in fig 3, wherein 5 are the insulating slices, 7 is the large power slice shown in fig 3, 8 is the sealing filler (e.g. epoxy resin), 9, 10 are the circular metallic cases separately and 11 is the air band. When 7 works with its two surfaces, the surface of 9 transfers heat and serves as a working area. The temperature of the surface of 10 is lower than that of the surface of 9 due to the separation of the air band 11.

Fig 5 shows a large power electronic electro-heating body made of insulating material, the chemical component of which is KMg(AlSi₃O₁₀)F₂, its thickness being 0.1mm. In the figure, 2 and 12 are the electrodes and 1 is the depositing area. The electrodes 2 and 12 are connected to the power source separately.

Fig 6 shows a sleeve shape large power electro-heating element, wherein 2 and 12 are the electrodes (a thin and long silver oar is connected with a metallic slice outward) and 13 is the electronic electro heating material shown in fig 5. Such material is rolled up to form a large power electro-heating coil. It can be used to heat or dewax a oil delivery pipe, or can be used to heat various kinds of conduits.

Fig 7 shows a sectional view of a superimposed large power electronic electro-heating material, wherein 14― is a metallic plate, 15― an enamel layer and 1 is a depositing surface. 1 is connected with trapezoidal silver oar electrodes. Such a large power electronic electro-heating material can be used for example as a glazing apparatus, or as an electro-heating surface for food treatment. The process for producing this material is as follows: The high-temperature-resistant insulating material is coated on a metal plate, e.g. enamel, then formed by means of sintering, after deposition treatment. The treatment of coating the high-temperature-resistant material and deposition are repeated once again. The above procedures are repeated for several times to finally form the electronic electro-heating material.

Fig 8 shows a large power body superimposed by means of the mechanical method, wherein 16― is the large power element shown in fig 3, 17― is the insulating layer and 18― the metallic radiating plate. The temperature of this equipment rises rapidly, it can be used to heat a large amount of liquid or gas flow.

Fig 9 shows a sectional view of a high-power honeycombed body, wherein 1― is the depositing layer, 20― the glass or porcelain tube, 21― the fixed case and 19― the insulating filler. While 1 is heating at work, the liquid passing through 20 is heated.

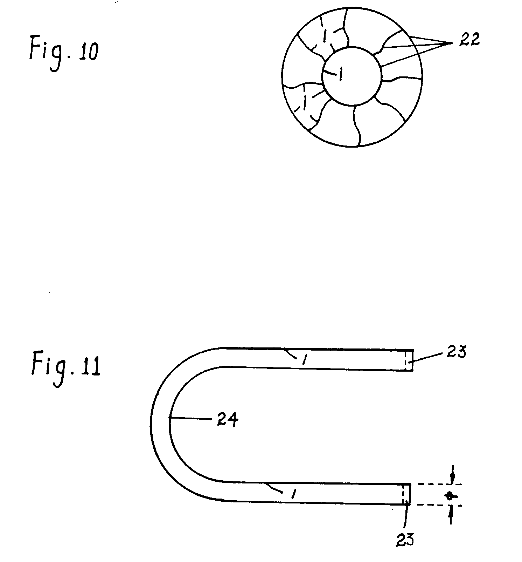

Fig 10 shows another high-power honeycombed body, wherein 22― is a thin wall of the high-temperature-resistant insulating material. All the inner wall surfaces have been treated by deposition. This equipment is a cheap heater for a large amount of gas.

Fig 11 shows a heating element made of glass or porcelain tube, wherein 1 is the depositing face, 24― the tube wall, 23― the electrodes and which is sealed by insulating glue and led out by conductors. Such an element can be immersed in the corrosive liquor (e.g. electroplating solution caustic soda solution) to heat it.

The advantages of this invention compared with the prior art are as follows: The material according to this invention can be used to up to 500°C without open fire and light, so it can be used as a heat source, where open fire is prohibited. As the auxiliary fire-proof material is no longer needed, the cost will be reduced.

The heat-inertia of the material according to this invention is small. Therefore, it can be used as heat source in a thermal field of constant temperature where the difference in the temperature desired is extremely small. Owing to the corrosion-proof character, the material according to this invention can be used as a heat source in corrosive environment. The material according to this invention has a long service life. The defroster of a refrigerator for example, has a service life as long as 10,000 hours. The ability to resist the impulse voltage of 220 V may be 10 million times.

The large area heating element according to this invention can be manufactured in very thin form. The thermal field produced is uniform, so that the field for its practical application is wide.

According to this invention the technological temperature used in its manufacture is moderate. The technological equipments are simple, so that it is easy to produce, and so that the cost is low.

The material of dielectric slice KMg (AlSi₃O₁₀)F₂ used in this invention is low in costs. For example material of 0.2mm thickness costs per cm² only RMB 0.004 Yuen. According to this invention a thin high-power electrothermal conversion body can be formed by a superimposing method to gain both effects, large power and long service life.
The material according to this invention contains an uncomplete oxide semiconductor. The speed of fomation of the charge carriers in the electrical field is high. The temperature of the element rises rapidly and the benefit of energy-saving is substantial. It is a unique electrothermal conversion material that is effective for energy-saving. Particularly, with the electro-heating elements according to this invention for heat is conducted by a dielectric substance instead of air as a heat-transfer medium, so that the thermal availability of the electric heating products is very high.

## Claims

1. A method for manufacturing an electronic electrothermal conversion material (4,13) comprising the following steps:
(a) dissolving two kinds of chloride,one of which is tin tetrachloride and the other is any one of
antimony trichloride, lead chloride, zinc chloride and indium chloride, into any one of the
organic liquors: ethyl alcohol, carbinol and acetone;
(b) preparing an aqueous solution of any of ammonium fluoride, hydrofluoric acid and tartaric acid as a reducing agent;
(c) rinsing and dewatering a high-temperature-resistant insulating material (3,5,17,22), putting it into a container (21,24), the temperature of which should be 350° - 550°C, and letting the insulating material (3,5,17,22) reach the same temperature as that of the container (21,14);
(d) uniformly atomizing the organic liquor from step (a) and the liquor from step (b) by high pressure air;
(e) putting the atomized organic liquor from steps (a) and (d) and the atomized liquor from steps (b) and (d) into the container (21,24) holding said high-temperature-resistant insulating material (3,5,17,22) whereby fluoric molecules as well as high valent metal oxide, low valent metal oxide and metal single substances, the metals of which correspond to the above-mentioned two kinds of chlorides are produced, which precipitate onto the high-temperature-resistant insulating material (3,5,17,22) to form a conductive semiconductor growth layer (1).

2. The method as claimed in claim 1, wherein said high-temperature-resistant insulating material (3,5,17,22) is any one of glass, quartz, graphite, mica, enamel and ceramic.

3. The method as claimed in claim 1 wherein the chemical component of said high-temperature-resistant insulating material (3,5,17,22) is any one of KMg (AlSi₃O₁₀)F₂ and Al₂O₃.

4. The method as claimed in claim 1, wherein the step of putting said two kinds of liquors into the container (21,24) consists of firstly putting the organic liquor of step (a) into the container (21,24), and then putting the liquor of step (b) into the container (21,24).

5. The method as claimed in claim 1, wherein the step of putting said two kinds of liquors into the container (21, 24) consists of simultaneously putting the organic liquor of step (a) and the liquor of step (b) into the container (21,24).

6. An electronic electrothermal conversion material, (4,13) obtainable by a process comprising steps
(a) dissolving two kinds of chloride,one of which is tin tetrachloride and the other is any one of
antimony trichloride, lead chloride, zinc chloride and indium chloride, into any one of the
organic liquors: ethyl alcohol, carbinol and acetone;
(b) preparing an aqueous solution of any of ammonium fluoride, hydrofluoric acid and tartaric acid as a reducing agent;
(c) rinsing and dewatering a high-temperature-resistant insulating material (3,5,17,11), putting it into a container (21,24), the temperature of which should be 350° - 550°C, and letting the insulating material (3,5,17,22) reach the same temperature as that of the container (21,14);
(d) uniformly atomizing the organic liquor from step (a) and the liquor from step (b) by high pressure air;
(e) putting the atomized organic liquor from steps (a) and (d) and the atomized liquor from steps (b) and (d) into the container (21,24) holding said high-temperature-resistant insulating material (3,5,17,22) whereby fluoric molecules as well as high valent metal oxide, low valent metal oxide and metal single substances, the metals of which correspond to the above-mentioned two kinds of chlorides are produced, which precipitate onto the high-temperature-resistant insulating material (3,5,17,22) to form a conductive semiconductor growth layer (1).

7. The material as claimed in claim 6, wherein said high-temperature-resistant insulating material (3,5,17,22) is any one of glass, quartz, graphite, mica, enamel and ceramic.

8. The material as claimed in claims 6 or 7, wherein said high-temperature-resistant insulating material (3,5,17,22) has one of the following shapes: slice, arc or sleeve, and said conductive semiconductor growth layer (1) is present on both surfaces of the high-temperature-resistant insulating material (3,5,17,22).

9. The material as claimed in claims 6 or 7, wherein said high-temperature-resistant insulating material (3,5,17,22) is multilayered, and at least one of said conductive semiconductor growth layers (1) is present between these layers.

10. The material as claimed in claims 6 or 7, wherein said high-temperature-resistant insulating material (3,5,17,22) is honeycombed and said conductive semiconductor growth layer (1) is present on the inner surface of the material (3,5,17,22).

11. The material as claimed in claim 6, wherein the chemical component of said high-temperature-resistant insulating material (3,5,17,22) is one of KMg(AlSi₃O₁₀)F₂ and Al₂O₃, and said conductive semiconductor growth layer (1) is present the surface of the material (3,5,17,22).

12. A power body comprising an electronic electrothermal conversion material (4,13) as defined in claim 6 wherein the electronic electrothermal conversion material (4,13) is connected to a power source via electrodes (2,12,23) from the conductive semiconductor growth layer (1).

## Patentansprüche

1. Verfahren zur Herstellung eines elektronisch-elektrothermischen Umwandlungsmaterials (4,13), welches die folgenden Stufen umfaßt:
(a) Auflösen zweier Arten von Chlorid, wovon eines Zinntetrachlorid ist und das andere ausgewählt ist aus Antimontrichlorid, Bleichlorid, Zinkchlorid und Indiumchlorid, in einer organischen Flüssigkeit, ausgewählt aus Ethylalkohol, Carbinol und Aceton;
(b) Zubereiten einer wäßrigen Lösung aus einer Verbindung, ausgewählt aus Ammoniumfluorid, Fluorwasserstoffsäure und Weinsäure als Reduktionsmittel;
(c) Spülen und Entwässern eines Hochtemperatur-beständigen, insulierenden Materials (3,5,17,22), Plazieren desselben in einem Behälter (21,24), dessen Temperatur zwischen 350 und 550°C liegen sollte, und Aufwärmenlassen des insulierenden Materials (3,5,17,22) auf dieselbe Temperatur wie die des Behälters (21,14);
(d) Einheitliches Atomisieren der organischen Flüssigkeit aus Stufe (a) und der Flüssigkeit aus Stufe (b) durch Luft mit hohem Druck;
(e) Füllen der atomisierten organischen Flüssigkeit aus den Stufen (a) und (d) und der atomisierten Flüssigkeit der Stufen (b) und (d) in den Behälter (21,24), der das Hochtemperatur-beständige, insulierende Material (3,5,17,22) enthält, wodurch sowohl fluorsaure Moleküle als auch Metalloxide mit hoher Valenz, Metalloxide mit niedriger Valenz und Metall-Einzelsubstanzen, deren Metalle den oben genannten zwei Arten von Chloriden entsprechen, gebildet werden, die auf dem Hochtemperatur-beständigen, insulierenden Material (3,5, 17, 22) abgeschieden werden, um eine gewachsene leitfähige Halbleiter-Schicht (1) zu bilden.

2. Verfahren nach Anspruch 1, worin das Hochtemperatur-beständige, insulierende Material (3,5,17,22) ausgewählt ist aus Glas, Quarz, Graphit, Mika, Email und Keramik.

3. Verfahren nach Anspruch 1, worin der chemische Bestandteil des Hochtemperatur-beständigen, insulierenden Materials (3,5,17,22) ausgewählt ist aus KMg(AlSi₃O₁₀)F₂ und Al₂O₃.

4. Verfahren nach Anspruch 1, worin die Stufe, in der die zwei Arten von Flüssigkeit in den Behälter (21,24) gefüllt werden, daraus besteht, daß zuerst die organische Flüssigkeit der Stufe (a) in den Behälter (21,24) und dann die Flüssigkeit der Stufe (b) in den Behälter (21,24) gefüllt wird.

5. Verfahren nach Anspruch 1, worin die Stufe, in der die zwei Arten von Flüssigkeiten in den Behälter (21,24) gefüllt werden, daraus besteht, daß die organische Flüssigkeit der Stufe (a) und die Flüssigkeit der Stufe (b) gleichzeitig in den Behälter (21,24) gefüllt werden.

6. Elektronisch-elektrothermisches Umwandlungsmaterial (4,13), erhältlich durch ein Verfahren, das die folgenden Stufen umfaßt:
(a) Auflösen zweier Arten von Chlorid, wovon eines Zinntetrachlorid ist und das andere ausgewählt ist aus Antimontrichlorid, Bleichlorid, Zinkchlorid und Indiumchlorid, in einer organischen Flüssigkeit, ausgewählt aus Ethylalkohol, Carbinol und Aceton;
(b) Zubereiten einer wäßrigen Lösung aus einer Verbindung, ausgewählt aus Ammoniumfluorid, Fluorwasserstoffsäure und Weinsäure als Reduktionsmittel;
(c) Spülen und Entwässern eines Hochtemperatur-beständigen, insulierenden Materials (3,5,17,22), Plazieren desselben in einem Behälter (21,24), dessen Temperatur zwischen 350 und 550°C liegen sollte, und Aufwärmenlassen des insulierenden Materials (3,5,17,22) auf dieselbe Temperatur wie die des Behälters (21,14);
(d) Einheitliches Atomisieren der organischen Flüssigkeit aus Stufe (a) und der Flüssigkeit aus Stufe (b) durch Luft mit hohem Druck;
(e) Füllen der atomisierten organischen Flüssigkeit aus den Stufen (a) und (d) und der atomisierten Flüssigkeit der Stufen (b) und (d) in den Behälter (21,24), der das Hochtemperatur-beständige, insulierende Material (3,5,17,22) enthält, wodurch sowohl fluorsaure Moleküle als auch Metalloxide mit hoher Valenz, Metalloxide mit niedriger Valenz und Metall-Einzel- substanzen, deren Metalle den oben genannten zwei Arten von Chloriden entsprechen, gebildet werden, die auf dem Hochtemperatur-beständigen, insulierenden Material (3,5, 17, 22) abgeschieden werden, um eine gewachsene leitfähige Halbleiter-Schicht (1) zu bilden.

7. Material nach Anspruch 6, worin das Hochtemperatur-beständige, insulierende Material (3,5,17,22) ausgewählt ist aus Glas, Quarz, Graphit, Mika, Email und Keramik.

8. Material nach Anspruch 6 oder 7, worin das Hochtemperatur-beständige, insulierende Material (3,5,17,22) eine der folgenden Formen hat: Scheibe, Bogen oder Buchse, und die gewachsene, leitfähige Halbleiter-Schicht (1) auf beiden Oberflächen des Hochtemperatur-beständigen, insulierenden Materials (3,5,17,22) vorhanden ist.

9. Material nach Anspruch 6 oder 7, worin das Hochtemperatur-beständige, insulierende Material (3,5,17,22) vielschichtig ist und mindestens eine der gewachsenen, leitfähigen Halbleiter-Schichten (1) zwischen diesen Schichten vorhanden ist.

10. Material nach Anspruch 6 oder 7, worin das Hochtemperatur-beständige, insulierende Material (3,5,17,22) wabenförmig ist und die gewachsene, leitfähige Halbleiter-Schicht (1) auf der inneren Oberfläche des Materials (3,5,17,22) vorhanden ist.

11. Material nach Anspruch 6, worin der chemische Bestandteil des Hochtemperatur-beständigen, insulierenden Materials (3,5,17,22) ausgewählt ist aus KMg(AlSi₃O₁₀)F₂ und Al₂O₃, und die gewachsene, leitfähige Halbleiter-Schicht (1) auf der Oberfläche des Materials (3,5,17,22) vorhanden ist.

12. Elektrische Vorrichtung, umfassend ein elektronisch-elektrothermisches Umwandlungsmaterial (4,13), das wie in Anspruch 6 definiert ist, wobei das elektronisch-elektrothermische Umwandlungsmaterial (4,13) über Elektroden (2,12,23) von der gewachsenen, leitfähigen HalbleiterSchicht (1) mit einer Stromquelle verbunden ist.

## Revendications

1. Procédé de fabrication d'un matériau électronique de conversion électrothermique (4,13) comprenant les étapes suivantes consistant à :
(a) dissoudre deux sortes de chlorures dont l'un est du tétrachlorure d'étain et l'autre est une des substances trichlorure d'antimoine, chlorure de plomb, chlorure de zinc et chlorure d'indium, dans l'un quelconque des liquides organiques : alcool éthylique, carbinol et acétone;
(b) préparer une solution aqueuse de l'une quelconque des substances fluoture d'ammonium, acide fluorhydrique et acide tartrique comme agent réducteur;
(c) rincer et égoutter un matériau isolant résistant à des températures élevées (3,5,17,22), le placer dans un récipient (21,24) dont la température devrait être comprise entre 350° et 550°C et laisser le matériau isolant (3,5,17,22) atteindre la même température que celle du récipient (21,14);
(d) atomiser uniformément le liquide organique de l'étape (a) et le liquide de l'étape (b) à l'aide d'air à haute pression;
(e) placer le liquide organique atomisé des étapes (a) et (d) et le liquide atomisé des étapes (b) et (d) dans le récipient (21,24) renfermant ledit matériau isolant résistant à des températures élevées (3,5,17,22), des molécules de fluor ainsi que les substances oxydes métalliques de valence élevée, oxydes métalliques de valence faible et métaux seuls dont les métaux correspondent aux deux sortes susmentionnées de chlorures étant produites, lesquelles précipitent sur le matériau isolant résistant à des températures élevées (3,5,17,22) pour former une couche conductrice de tirage de semi-conducteur (1).

2. Procédé selon la revendication 1, dans lequel ledit matériau isolant résistant à des températures élevées (3,5,17,22) est un quelconque des matériaux verte, quartz, graphite, mica, émail et céramique.

3. Procédé selon la revendication 1, dans lequel le composant chimique dudit matériau isolant résistant à des températures élevées (3,5,17,22) est un quelconque des composants KMg (AlSi₃O₁₀)F₂ et Al₂O₃.

4. Procédé selon la revendication 1, dans lequel l'étape consistant à placer lesdites deux sortes de liquides dans le récipient (21,24) consiste à placer d'abord le liquide organique de l'étape (a) dans le récipient (21,24), puis à placer le liquide de l'étape (b) dans le récipient (21,24).

5. Procédé selon la revendication 1, dans lequel l'étape consistant à placer lesdites deux sortes de liquides dans le récipient (21,24) consiste à placer simultanément le liquide organique de l'étape (a) et le liquide de l'étape (b) dans le récipient (21,24).

6. Matériau électronique de conversion électrothermique (4,13) qu'il est possible d'obtenir par un procédé comprenant les étapes consistant à :
(a) dissoudre deux sortes de chlorures dont l'un est du tétrachlorure d'étain et l'autre est une quelconque des substances trichlorure d'antimoine, chlorure de plomb, chlorure de zinc et chlorure d'indium, dans l'un quelconque des liquides organiques : alcool éthylique, carbinol et acétone ;
(b) préparer une solution aqueuse de l'une quelconque des substances fluorure d'ammonium, acide fluorhydrique et acide tartrique comme agent réducteur ;
(c) rincer et égoutter un matériau isolant résistant à des températures élevées (3,5,17,11), le placer dans un récipient (21,24) dont la température devrait être comprise entre 350° et 550°C et laisser le matériau isolant (3,5,17,22) atteindre la même température que celle du récipient (21,24) ;
(d) atomiser uniformément le liquide organique de l'étape (a) et le liquide de l'étape (b) à l'aide d'air haute pression ;
(e) placer le liquide organique atomisé des étapes (a) et (d) et le liquide atomisé des étapes (b) et (d) dans le récipient (21,24) renfermant ledit matériau isolant résistant à des températures élevées (3,5,17,22), des molécules de fluor de même que les substances oxydes métalliques de valence élevée, oxydes métalliques de valence faible et métaux simples dont les métaux correspondent aux deux sortes susmentionnées de chlorures étant produites, lesquelles précipitent sur le matériau isolant résistant à des températures élevées (3,5,17,22) pour former une couche conductrice de tirage de semi-conducteur (1).

7. Matériau selon la revendication 6, dans lequel ledit matériau isolant résistant à des températures élevées (3,5,17,22) est un quelconque des matériaux verte, quartz, graphite, mica, émail et céramique.

8. Matériau selon la revendication 6 ou 7, dans lequel ledit matériau isolant résistant à des températures élevées (3,5,17,22) présente une des formes suivantes : galette, arc ou manchon et ladite couche conductrice de tirage de semi-conducteur (1) est présente sur les deux surfaces du matériau isolant résistant à des températures élevées (3,5,17,22).

9. Matériau selon la revendication 6 ou 7, dans lequel ledit matériau isolant résistant à des températures élevées (3,5,17,22) est multicouche et au moins une desdites couches conductrices de tirage de semi-conducteur (1) est présente entre ces couches.

10. Matériau selon la revendication 6 ou 7, dans lequel ledit matériau isolant résistant à des températures élevées (3,5,17,22) est alvéolaire et ladite couche conductrice de tirage de semi-conducteur (1) est présente sur la surface interne du matériau (3,5,17,22).

11. Matériau selon la revendication 6, dans lequel le composant chimique dudit matériau isolant résistant à des températures élevées (3,5,17,22) est un des matériaux KMg(AlSi₃O₁₀)F₂ et Al₂O₃ et ladite couche conductrice de tirage de semi-conducteur (1) est présente sur la surface du matériau (3,5,17,22).

12. Corps électrique comprenant un matériau électronique de conversion électrothermique (4,13) selon la revendication 6, le matériau électronique de conversion électrothermique (4,13) étant connecté à une source de courant par des électrodes (2,12,23) émanant de la couche conductrice de tirage de semi-conducteur (1).
